# EUROPEAN PATENT APPLICATION

(11) **EP 3 419 052 A1**
(43) Date of publication of application: **26.12.2018**
(21) Application number: 17889948.0
(22) Date of filing: 03.01.2017
(51) Int. Cl.: H01L 23/488

(54) **SUBSTRATE STRUCTURE FOR PACKAGING CHIP**

(71) Applicant: Shenzhen Goodix Technology Co., Ltd., Shenzhen, Guangdong 518045 (CN)
(72) Inventor: YANG, Ke, Shenzhen Guangdong 518045 (CN); LIU, Kai, Shenzhen Guangdong 518045 (CN); ZENG, Shanshan, Shenzhen Guangdong 518045 (CN)
(74) Representative: Valea AB
(86) International application number: PCT/CN2017/000030
(87) International publication number: WO 2018/126336

(57) **Abstract**

A substrate for chip package and a chip package are provided. A portion on an upper surface of a base material of the substrate that is uncovered by a solder mask is provided with at least one substrate feature point. The upper surface of the base material of the substrate is provided with at least one slot. The slot is configured to guide an irregularly flowing packaging material in the course of chip packaging. The problem of covering the substrate feature point due to irregular flowing of a packaging material is solved with the substrate with no need to re-design a different mold and substrate feature point.

## Description

### TECHNICAL FIELD

The present application relates to the technical field of chip package, and in particular, relates to a substrate for chip package.

### BACKGROUND

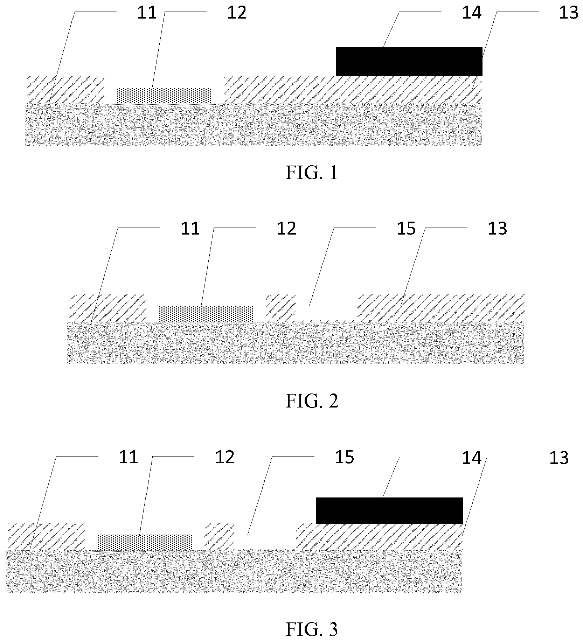

During the process of chip package, due to the effect of mold pressing, phenomenon of packaging material overflow is common. For example, epoxy resin molding compound (EMC) slight overflows in the vicinity of an exhaust slot of a mold. Such overflow phenomena exhibit an uncontrollable irregular flowing state of such packaging materials as the epoxy resin molding compound and the like. In this case, the appearance of the substrate may be affected, and the related substrate feature point of the plastically packaged substrate may be covered. Referring to FIG. 1, at least one substrate feature point 12 is arranged at a portion, which is not coated by a solder mask 13, on an upper surface of a base material 11 of the substrate. Generally, the substrate feature point 12 (Cu pad) has a thickness of 10 to 20 µm. The solder mask 13 on the upper surface of the base material 11 of the substrate may project relative to the substrate feature point due to the thickness of the copper (Cu) foil. If an exhaust slot 14 is arranged in the vicinity of the substrate feature point 12., and when the epoxy resin molding compound in the vicinity of the exhaust slot 14 overflows, the overflowing epoxy resin molding compound may flow to the upper part of the substrate feature point 12 and covers the substrate feature point 12.

Covering the substrate feature point may severely affect the process precision and efficiency of the each stage in the subsequent process. If different molds and substrate feature points are designed for different products, product cost may be increased.

### SUMMARY

In view of the above, the present application provides a substrate for chip package. With the substrate, the problem of covering the substrate feature point due to irregular flowing of a packaging material is prevented with no need to re-design a different mold and substrate feature point.

The present application provides a substrate for chip package. A portion, which is not coated by a solder mask, on an upper surface of a base material of the substrate is provided with at least one substrate feature point. The upper surface of the base material of the substrate is provided with at least one slot. The slot is configured to guide an irregularly flowing packaging material in the course of chip packaging.

As known from the above technical solution, at least one slot is arranged on the upper surface of the base material of the substrate according to the present application. The irregularly flowing packaging material in the course of chip packaging may be guided to the slot, such that the package material may not be randomly distributed. In this way, the normal appearance of the substrate is not affected, and the substrate feature point is covered. In addition, according to the present application, there is no need to re-design a different mold and substrate feature point, and thus product cost may not be increased.

### BRIEF DESCRIPTION OF THE DRAWINGS

To more clearly describe technical solutions according to the embodiments of the present application or in the prior art, drawings that are to be referred for description of the embodiments or the prior art are briefly described hereinafter. Apparently, the drawings described hereinafter merely illustrate some embodiments of the present application. Persons of ordinary skill in the art may also derive other drawings based on the drawings described herein.
FIG. 1 is a schematic structural view of a substrate for chip package;
FIG. 2 is a schematic view of a substrate for chip package according to some embodiments of the present application;
FIG. 3 is a schematic view of a substrate for chip package according to some other embodiments of the present application; FIG. 4a and FIG. 4b are schematic views of a substrate for a chip package according to still some other embodiments of the present application.

### DETAILED DESCRIPTION

According to the present application, at least one slot is arranged on the upper surface of the base material of the substrate. The irregularly flowing package material in the course of chip packaging may be guided to the slot, such that the package material may not be randomly distributed. In this way, the normal appearance of the substrate is not affected, and the substrate feature point is covered. In addition, according to the present application, there is no need to re-design a different mold and substrate feature point, and thus product cost may not be increased.

Definitely, the implementation of any technical solution of the present application does not need to achieve all the above advantages.

To make a person skilled in the art better understand the technical solutions of the present application, the technical solutions in the embodiments of the present application are described clearly and completely with reference to the accompanying drawings in the embodiments of the present application. Apparently, the described embodiments are merely some of rather than all of the embodiments of the present application. Based on the embodiments of the present application, all other embodiments derived by persons of ordinary skill in the art without any creative efforts shall fall within the protection scope of the present application.

Specific implementations of the present application are further described hereinafter with reference to drawings of the present application.

Referring to FIG. 2, one embodiment of the present application provides a substrate for chip package. At least one substrate feature point 12 is provided on a portion of an upper surface of the base material 11 of the substrate which is not covered by a solder mask 13. At least one slot 15 is arranged on the upper surface of the base material 11 of the substrate. The slot 15 is configured to guide an irregularly flowing package material in the course of chip packaging.

Specifically, the substrate feature point 12 is an optical positioning point.

According to the present application, at least one slot 15 is arranged on the upper surface of the base material 11 of the substrate. The irregularly flowing package material in the course of chip packaging may be guided to the slot 15, such that the package material may not be randomly distributed. In this way, the normal appearance of the substrate is not affected, and the substrate feature point is covered. In addition, according to the present application, there is no need to re-design a different mold and substrate feature point, and thus product cost may not be increased.

Referring to FIG. 3, another embodiment of the present application provides a substrate for chip package. At least one substrate feature point 12 is arranged on an upper surface, which is not covered by a solder mask 13, of a base material 11 of the substrate. At least one exhaust slot 14 is arranged on an upper surface of the solder mask 13. At least one slot 15 is arranged on the upper surface of the base material 11 of the substrate. The slot 15 is configured to guide an epoxy resin molding plastic overflowing from the exhaust slot 14.

Specifically, the substrate feature point 12 is an optical positioning point.

According to the present application, at least one slot 15 is arranged on the upper surface of the base material 11 of the substrate. The epoxy resin overflowing from the exhaust slot 14 in the course of chip packaging may be guided to the slot 15, such that the epoxy resin may not be randomly distributed. In this way, the normal appearance of the substrate is not affected, and the substrate feature point is covered. In addition, according to the present application, there is no need to re-design a different mold and substrate feature point, and thus product cost may not be increased.

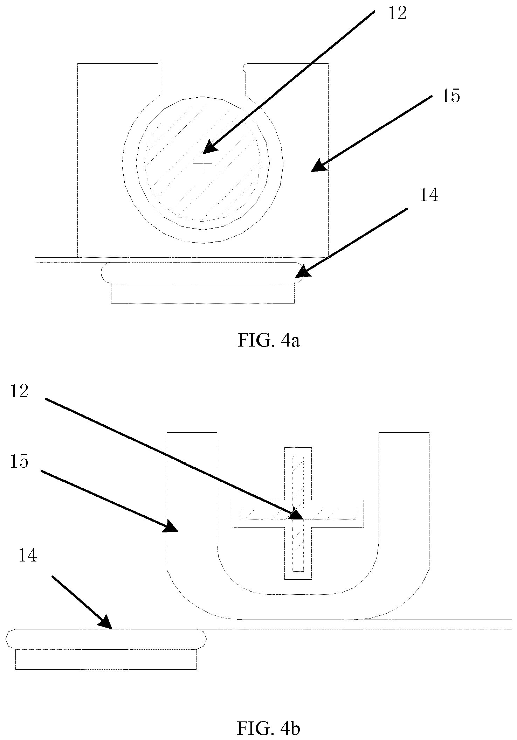

In one specific implementation of the present application, referring to FIG. 4a and FIG. 4b, a distance from the slot 15 to the exhaust slot 14 is greater than or equal to 50 µm.

According to the present application, the slot 15 is arranged in the vicinity of the slot 15, which achieves the effect of a guide slot. When the package material overflows, under different pressure intensities in the vicinity of the slot 15 and inside the slot 15, the overflowing package material may flow in accordance with the shape of the slot 15. In this way, the overflowing packaging material does not affect the appearance of the substrate.

In another specific implementation of the present application, referring to FIG. 4a and FIG. 4b, a distance from the slot 15 to the substrate feature point 12 is greater than or equal to 100 µm.

According to the present application, the slot 15 is arranged in the vicinity of the substrate feature point 12, which achieves the effect of a guide slot. When the packaging material overflows, under different pressure intensities in the vicinity of the slot 15 and inside the slot 15, the overflowing packaging material may flow in accordance with the shape of the slot 15. In this way, the overflowing packaging material does not affect the appearance of the substrate.

The shape of the slot 15 is such defined that the substrate feature point is surrounded, such that the overflowing packaging material is further prevented from covering the substrate feature point 12.

In still another specific implementation of the present application, the shape of the slot 15 is designed according to a space in which the slot is located. Therefore, according to an embodiment of the present application, the shape of the slot 15 may be defined according to the spaces in which the base material 11 of the substrate, the substrate feature point 12 and the exhaust slot 14 are located.

In still another specific implementation of the present application, a depth of the slot 15 is determined according to a thickness of the solder mask 13 and a thickness of a cupper foil. If the thicknesses of the solder mask 13 and the cupper foil are small, the depth of the slot 15 is also small; and if the thicknesses of the solder mask 13 and the cupper foil are great, the depth of the slot 15 is great.

In still another specific implementation of the present application, the shape of the substrate feature point 12 varies according to a dimension of the slot 15. The shape of the substrate feature point 12 is not fixed, and varies according to the dimension of the slot 15 on the upper surface of the base material 11 of the substrate, such that the substrate feature point is not covered by the packaging material.

Although the preferred embodiments of the present application are described above, once knowing the basic creative concept, a person skilled in the art can make other modifications and variations to these embodiments. Therefore, the appended claims are intended to be construed as covering the preferred embodiments and all the modifications and variations falling within the scope of the present application. Obviously, a person skilled in the art can make various modifications and variations to the present application without departing from the spirit and scope of the present application. In this way, the present application is intended to cover the modifications and variations if they fall within the scope of the appended claims of the present application and equivalent technologies thereof.

## Claims

1. A substrate for chip package, comprising a portion on an upper surface of a base material of the substrate, wherein the portion is uncovered by a solder mask, and is provided with at least one substrate feature point;
wherein the upper surface of the base material of the substrate is provided with at least one slot, the slot being configured to guide an irregularly flowing packaging material in a course of chip packaging.

2. The substrate for chip package according to claim 1, wherein an upper surface of the solder mask is provided with at least one exhaust slot, and the slot is configured to guide an epoxy resin molding plastic overflowing from the at least one exhaust slot.

3. The substrate for chip package according to claim 2, wherein a distance from the slot to the at least one exhaust slot is greater than or equal to 50 µm.

4. The substrate for chip package according to claim 1, wherein a distance from the slot to the substrate feature point is greater than or equal to 100 µm.

5. The substrate for chip package according to claim 4, wherein the slot has a shape designed to surround the substrate feature point.

6. The substrate for chip package according to claim 1, wherein the shape of the slot is designed based on a space in which the at least one slot is located.

7. The substrate for chip package according to claim 1, wherein a depth of the slot is determined based on a thickness of the solder mask and a thickness of a copper foil.

8. The substrate for chip package according to claim 1, wherein a shape of the substrate feature point varies based on a dimension of the slot.

9. The substrate for chip package according to any one of claims 1 to 8, wherein the substrate feature point is an optical positioning point.
